# EUROPÄISCHE PATENTSCHRIFT

(11) **EP 0 542 093 B1**
(45) Veröffentlichungstag und Bekanntmachung des Hinweises auf die Patenterteilung: **13.03.1996**
(21) Anmeldenummer: 92118776.1
(22) Anmeldetag: 02.11.1992
(51) Int. Cl.: H05K 13/02, H05K 13/00

(54) **Einrichtung zur Bereitstellung von gegurteten Bauelementen**
Delivery device for belted components
Dispositif de mise à dispositif de composants insérés dans une bande

(30) Priorität: 12.11.1991 DE 4137194
(43) Veröffentlichungstag der Anmeldung: 19.05.1993
(73) Patentinhaber: SIEMENS AKTIENGESELLSCHAFT, D-80333 München (DE)
(72) Erfinder: Rohm, Rainer, Dipl.-Ing., W-8000 München 71 (DE); Weckel, Sebastian, Dipl.-Ing., W-8196 Erasburg (DE); Wacker, Josef, Dipl.-Ing. (FH), W-8137 Höhenrain (DE)

(56) Entgegenhaltungen:
- EP-A- 0 016 368
- DE-U- 9 016 569
- US-A- 5 024 720

## Beschreibung

Bei der automatischen Bestückung von Leiterplatten mit oberflächenmontierbaren Bauelementen, den sog. SMD-Bauelementen, erfolgt die Bereitstellung der Bauelemente über verschiedene Arten von Zuführmodulen, wobei hier jedoch der Bereitstellung von gegurteten Bauelementen eine besondere Bedeutung zukommt. Die Anlieferform im Gurt ist besonders automatisierungsfreundlich, da die Bauelemente bereits vereinzelt sind und die Verpackung im Gurt weitgehende Sicherheit gegen Vertauschung gewährleistet. In den einzelnen Zuführmodulen für gegurtete Bauelemente werden die Gurte mit den Bauelementen von einer Gurtspule abgespult, in horizontaler Richtung einer Entnahmeposition für die Bauelemente zugeführt und dann wieder in horizontaler Richtung zurückgeführt. Die Entnahmeposition befindet sich dabei entweder oben oder seitlich im Bereich der Gurtumlenkung, so daß die Bauelemente entweder mit einer vertikal ausgerichteten Saugpipette von oben her oder mit einer horizontal ausgerichteten Saugpipette von der Seite her aufgenommen werden können. Die Abdeckfolie der Bauelemente wird noch vor Erreichen der Abholposition abgezogen und auf eine angetriebene Spule aufgewickelt (vgl. EP-A-0 016 368).

Die vorstehend beschriebenen bekannten Zuführmodule für gegurtete Bauelemente können nur einreihig am Bestückautomaten untergebracht werden. Für die Bestückung verschiedener Leiterplattenlose ist dann jeweils eine Umrüstung des Bestückautomaten erforderlich, wobei diese Umrüstung durch manuelles Wechseln einzelner oder mehrerer Zuführmodule oder durch automatisches Wechseln von Tischen mit mehreren Zuführmodulen vorgenommen werden kann.

Der im Anspruch 1 angegebenen Erfindung liegt das Problem zugrunde, eine Einrichtung zur Bereitstellung von gegurteten Bauelementen mit einer großen Anzahl von verfügbaren Zuführmodulen zu schaffen.

Die mit der Erfindung erzielten Vorteile bestehen insbesondere darin, daß durch die spezielle Gurtführung in Verbindung mit der Anordnung der Abholposition im Scheitelbereich der Gurtumlenkung eine Anordnung der Zuführmodule in mehreren Reihen und damit eine flächenmäßige Bereitstellung der Bauelemente ermöglicht wird. Die Zahl der vom Bestückkopf eines Bestückautomaten erreichbaren Zuführmodule kann damit deutlich erhöht werden, so daß verschiedene Leiterplattenlose ohne Umrüstung der Bauelemente-Bereitstellung bestückt werden können.

Vorteilhafte Ausgestaltungen der Erfindung sind in den Ansprüchen 2 bis 10 angegeben.

Die Ausgestaltung nach Anspruch 2 erleichtert die Anordnung einzelner Zuführmodule in einer Reihe und die Hintereinanderanordnung mehrerer derartiger Reihen von Zuführmodulen. Können die einzelnen Träger dann gemäß Anspruch 2 aus der Einrichtung herausgezogen werden, so wird hierdurch die Wartung und Nachfüllung von Bauelementen wesentlich erleichtert.

Die Weiterbildung nach Anspruch 4 ermöglicht durch die rasch wechselbaren Kassetten eine weitere Beschleunigung beim Einlegen von Gurtspulen.

Wird gemäß Anspruch 5 die Transport-Einrichtung für den Gurt auf dem Träger des entsprechenden Zuführmoduls angeordnet, so kann hierdurch eine erhebliche bauliche Vereinfachung der gesamten Einrichtung erzielt werden.

Die Ausgestaltung nach Anspruch 6 bietet die Möglichkeit, mit dem Wechsel einer Kassette gleichzeitig auch die Entsorgung des Gurtabfalls vorzunehmen. Dabei ist es besonders günstig, wenn der Antriebsmotor für die entsprechende Spule nicht in den einzelnen Kassetten, sondern gemäß Anspruch 7 auf dem Träger angeordnet ist.

Die Weiterbildung nach Anspruch 8 bietet die Möglichkeit, mit dem Wechsel einer Kassette gleichzeitig auch die Entsorgung der vom Gurt abgezogenen Abdeckfolie vorzunehmen. Gemäß Anspruch 9 können das Abziehen und die Aufnahme der Abdeckfolien mit geringem Aufwand durch eine in der Kassette angeordnete Spule vorgenommen werden. Auch in diesem Fall ist es dann gemäß Anspruch 10 wieder günstig, den Antriebsmotor für diese Spule auf dem Träger anzuordnen.

Ein Ausführungsbeispiel der Erfindung ist in der Zeichnung dargestellt und wird im folgenden näher beschrieben.

Es zeigen:
Figur 1 das Grundprinzip einer flächenmäßigen Bereitstellung von gegurteten Bauelementen,
Figur 2 eine Seitenansicht von drei nebeneinander auf einem ausziehbaren plattenförmigen Träger angeordneten Zuführmodulen, und
Figur 3 eine auswechselbare Kassette der in Figur 2 dargestellten Zuführmodule.

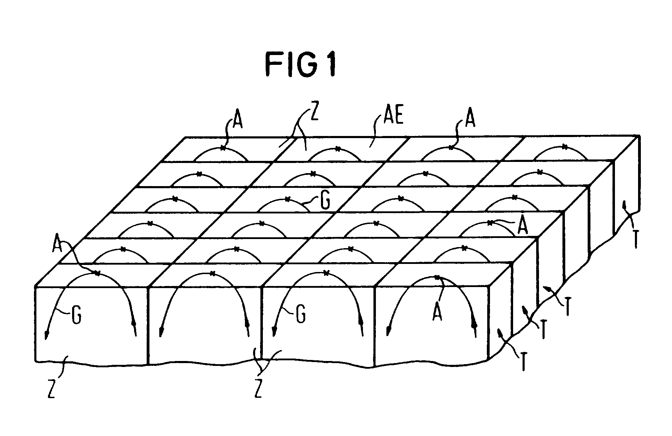

Figur 1 zeigt in stark vereinfachter schematischer Darstellung das Prinzip einer erfindungsgemäßen Einrichtung zur Bereitstellung von gegurteten Bauelementen. Die dargestellte Einrichtung umfaßt sechs hintereinander angeordnete Reihen mit jeweils vier nebeneinander angeordneten Zuführmodulen Z. Die vier Zuführmodule Z einer Reihe sind dabei jeweils auf einem separat herausziehbaren Träger T angeordnet. Jedes Zuführmodul Z weist eine von unten kommende und nach unten wegführende Führung des Gurtes G auf, wobei die Abholpositionen A der Bauelemente jeweils im Scheitelbereich der Gurtumlenkung liegen. Die vorstehend beschriebene und in Figur 1 durch nicht näher bezeichnete Pfeile aufgezeigte Gurtführung ermöglicht die Anordnung sämtlicher Abholpositionen A in einer gemeinsamen Abhol-Ebene AE und damit eine flächenmäßige Bereitstellung der gegurteten Bauelemente.

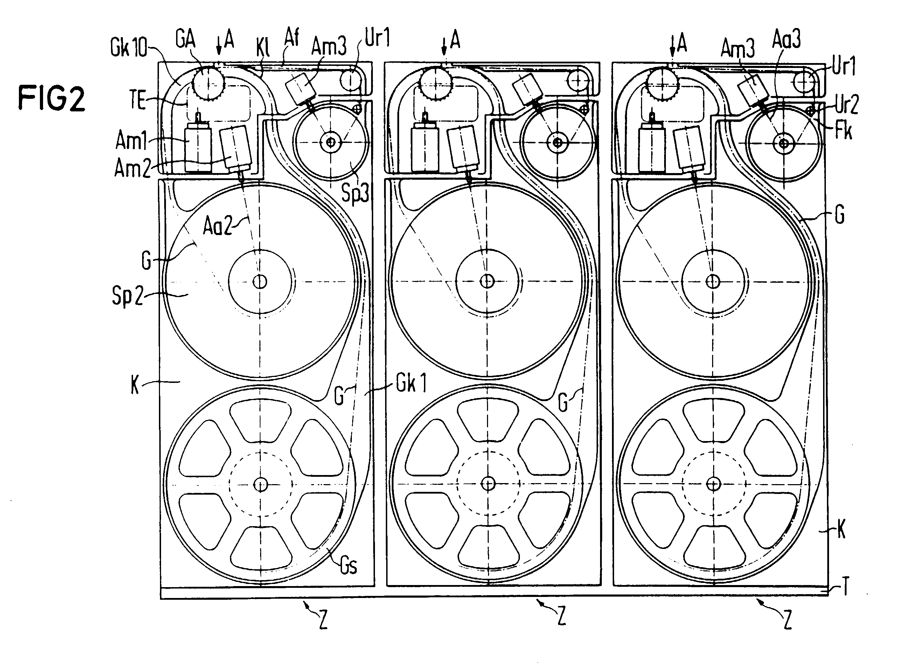

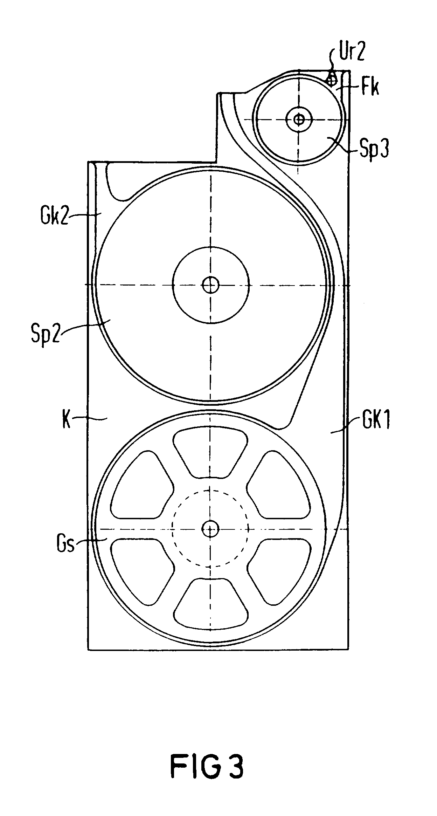

Figur 2 zeigt einen plattenförmigen Träger T, auf welchem nebeneinander drei Zuführmodule Z angeordnet sind. Jeder dieser Zuführmodule Z ist mit einer auswechselbaren Kassette K ausgerüstet, zu deren Erläuterung zusätzlich auf Figur 3 verwiesen wird. Im unteren Bereich einer Kassette K ist die mit Gs bezeichnete Gurtspule drehbar angeordnet. Ausgehend von der Gurtspule Gs führt ein mit Gk1 bezeichneter Gurtführungskanal nach oben. Oberhalb der Gurtspule Gs ist eine mit Sp2 bezeichnete Spule zur Aufnahme des leeren Gurtes G angeordnet. Zu dieser Spule Sp2 führt ein von oben kommender Gurtführungskanal Gk2. Im oberen rechten Bereich der in Figur 3 dargestellten Kassette K ist eine weitere Spule Sp3 drehbar angeordnet, wobei diese Spule Sp3 zur Aufnahme der vom Gurt G abzuziehenden Abdeckfolie bestimmt ist. Von oben her führt zu der Spule Sp3 ein Führungskanal Fk mit einer im linken Wandbereich angeordneten Umlenkrolle Ur2.

Gemäß Figur 2 wird der von der Gurtspule Gs ablaufende und durch eine strichpunktierte Linie dargestellte Gurt G durch den Gurtführungskanal Gk1 nach oben geführt und dann in einem entsprechend gekrümmten Gurtführungskanal Gk10 des Trägers T wieder nach unten in den Gurtführungskanal Gk2 umgelenkt und schließlich auf die Spule Sp2 aufgewickelt. Im Scheitelbereich des Gurtführungskanals Gk10 befindet sich die senkrecht von oben her zugangliche Abholposition A für die im Gurt G enthaltenen Bauelemente. In Transportrichtung des Gurtes G gesehen befindet sich kurz hinter der Abholposition A das Gurt-Antriebsrad GA einer durch strichpunktierte Linien angedeuteten Transport-Einrichtung TE. Diese Transport-Einrichtung TE und ihr mit Am1 bezeichneter Antriebsmotor sind fest auf dem Träger T angeordnet. Die Transport-Einrichtung TE, deren gezahntes Gurt-Antriebsrad GA in die Tranportperforation des Gurtes G eingreift, ist in ähnlicher Weise aufgebaut wie die Transport-Einrichtung einer Filmkamera.

Der Antrieb der zur Aufnahme des leeren Gurtes G bestimmten Spule Sp2 erfolgt über einen Antriebsmotor Am2, der ebenfalls fest auf dem plattenförmigen Träger T angeordnet ist. Die Ankopplung des Antriebsmotors Am2 an die Spule Sp2, die beispielsweise über ein Kegelrad und ein Tellerrad vorgenommen wird, ist in Figur 2 lediglich durch eine strichpunktierte Antriebsachse Aa2 angedeutet.

Die in Figur 2 durch eine strichpunktierte Linie angedeutete Abdeckfolie Af des Gurtes G wird über einen Keil Kl entgegengesetzt zur Transportrichtung des Gurtes G abgezogen und über eine fest am Träger T angebrachte Umlenkrolle Ur1 sowie die bereits erwähnte Umlenkrolle Ur2 und den Führungskanal Fk auf die Spule Sp3 aufgewickelt. Der zum Abziehen der Abdeckfolie Af erforderliche Antrieb der Spule Sp3 erfolgt über einen Antriebsmotor Am3, der fest auf dem Träger T angeordnet ist. Die Ankopplung dieses Antriebsmotors Am3 an die Spule Sp3 ist in Figur 2 lediglich durch eine strichpunktierte Antriebsachse Aa3 angedeutet.

Der in Figur 2 dargestellte Träger T mit den drei Zuführmodulen Z ist mit mehreren gleichartigen Trägern T in einen Wagen zur Bereitstellung der Bauelemente oder in den Bestückautomaten selbst eingebaut. Die einzelnen hintereinander angeordneten Träger T sind zur leichteren Wartung und zum Auswechseln der Kassetten K einzeln herausziehbar. Da die einzelnen Kassetten K extern vorgerüstet werden können, kann ihre Auswechslung sehr rasch vorgenommen werden.

In dem vorstehend beschriebenen Ausführungsbeispiel werden die leeren Gurte G in die Kassetten K geführt und dort auf die Spulen Sp2 aufgewickelt. Es ist aber auch möglich, die leeren Gurte G nach unten wegzuführen und sie dann unterhalb der Bauelemente-Bereitstellung zur Verringerung des Abfallvolumens zu zerkleinern.

## Patentansprüche

1. Einrichtung zur Bereitstellung von in einem Gurt (G) enthaltenen gegurteten Bauelementen bei der automatischen Bestückung von Leiterplatten, mit
- mehreren nebeneinander und hintereinander angeordneten Zuführmodulen (Z), deren Abholpositionen (A) für die jeweiligen Bauelemente in einer gemeinsamen Abhol-Ebene (AE) liegen, wobei
- jeder Zuführmodul (Z) eine von unten kommende und nach unten wegführende Führung des Gurtes (G) mit einer im Scheitelbereich der Gurtumlenkung liegenden Abholposition (A) der Bauelemente aufweist.

2. Einrichtung nach Anspruch 1,
**dadurch gekennzeichnet**,
daß nebeneinander angeordnete Zuführmodule (Z) an einem gemeinsamen plattenförmigen Träger (T) angebracht sind und daß mehrere plattenförmige Träger (T) hintereinander angeordnet sind.

3. Einrichtung nach Anspruch 2,
**gekennzeichnet durch**
ausziehbare Träger (T).

4. Einrichtung nach Anspruch 2 oder 3,
**dadurch gekennzeichnet**,
daß jeder Zuführmodul (Z) eine auswechselbar am Träger (T) angebrachte Kassette (K) zur Aufnahme von Gurtspulen (Gs) besitzt.

5. Einrichtung nach Anspruch 4,
**dadurch gekennzeichnet**,
daß die Transport-Einrichtung (TE) für den schrittweisen Vorschub eines Gurtes (G) fest auf dem zugeordneten Träger (T) angeordnet ist.

6. Einrichtung nach Anspruch 4 oder 5,
**dadurch gekennzeichnet**,
daß in der Kassette (K) eine angetriebene Spule (Sp2) zur Aufnahme des leeren Gurtes (G) untergebracht ist.

7. Einrichtung nach Anspruch 6,
**dadurch gekennzeichnet,**
daß der Spule (Sp2) ein fest am Träger (T) angebrachter Antriebsmotor (Am2) zugeordnet ist.

8. Einrichtung nach einem der Ansprüche 4 bis 7,
**dadurch gekennzeichnet,**
daß in die Kassette (K) eine Abzugseinrichtung und eine Aufnahmeeinrichtung für die Abdeckfolie (Af) des Gurtes (G) integriert sind.

9. Einrichtung nach Anspruch 8,
**dadurch gekennzeichnet,**
daß die Abzugseinrichtung und die Aufnahmeeinrichtung durch eine angetriebene Spule (Sp3) zur Aufnahme der Abdeckfolie (Af) gebildet ist.

10. Einrichtung nach Anspruch 9,
**dadurch gekennzeichnet,**
daß der Spule (Sp3) ein fest am Träger (T) angebrachter Antriebsmotor (Am3) zugeordnet ist.

## Claims

1. Device for providing taped components which are contained in a tape (G) for the automatic fitting of printed circuit boards, having
- a plurality of feed modules (Z) which are arranged side by side and one behind the other and whose pick-up positions (A) for the respective components lie in a common pick-up plane (AE),
- each feed module (Z) having a guide, which comes from underneath and leads away downwards, for the tape (G) having a pick-up position (A) for the components which is located in the apex region of the tape band.

2. Device according to Claim 1, characterized in that feed modules (Z) which are arranged side by side are fitted on a common carrier (T) in the form of a board, and in that a plurality of carriers (T) which are in the form of boards are arranged one behind the other.

3. Device according to Claim 2, characterized by withdrawable carriers (T).

4. Device according to Claim 2 or 3, characterized in that each feed module (Z) has a cassette (K) which is fitted replaceably on the carrier (T), for holding tape spools (Gs).

5. Device according to Claim 4, characterized in that the transportation device (TE) for feeding the belt (G) step by step is arranged permanently on the associated carrier (T).

6. Device according to Claim 4 or 5, characterized in that a driven spool (Sp2) for holding the empty tape (G) is accommodated in the cassette (K).

7. Device according to Claim 6, characterized in that the spool (Sp2) is assigned a drive motor (Am2) which is permanently fitted on the carrier (T).

8. Device according to one of Claims 4 to 7, characterized in that a pulling-off device and a holding device for the covering film (Af) of the tape (G) are integrated in the cassette (K).

9. Device according to Claim 8, characterized in that the pulling-off device and the holding device are formed by a driven spool (Sp3) for holding the covering film (Af).

10. Device according to Claim 9, characterized in that the spool (Sp3) is assigned a drive motor (Am3) which is permanently fitted on the carrier (T).

## Revendications

1. Dispositif pour la mise à disposition de composants contenus dans une bande (G), lors de l'équipement automatique de plaquettes à circuits imprimés, comportant
- plusieurs modules d'amenée (Z) disposés côte-à-côte et les uns derrière les autres et dont les positions de prélèvement (A) pour les composants respectifs sont situées dans un plan de prélèvement commun (AE),
- chaque module d'amenée (Z) comportant un guide de la bande (G), qui arrive du bas et repart vers le bas, avec une position de prélèvement (A) des composants située dans la zone sommitale du renvoi de la bande.

2. Dispositif suivant la revendication 1, caractérisé par le fait que des modules d'amenée (Z) situés côte-à-côte sont disposés sur un support commun en forme de plaques (T) et que plusieurs supports en forme de plaques (T) sont disposés les uns derrière les autres.

3. Dispositif suivant la revendication 2, caractérisé par des supports (T) que l'on peut retirer.

4. Dispositif suivant la revendication 2 ou 3, caractérisé par le fait que chaque module d'amenée (Z) possède une cassette (K) montée d'une manière interchangeable sur le support (T) et servant à recevoir des bobines de bande (Gs).

5. Dispositif suivant la revendication 4, caractérisé par le fait que le dispositif de transport (TE) pour l'avance pas-à-pas d'une bande (G) est disposé de façon fixe sur le support associé (T).

6. Dispositif suivant la revendication 4 ou 5, caractérisé par le fait qu'une bobine entraînée (Sp2) servant à recevoir la bande vide (G) est logée dans la cassette (K).

7. Dispositif suivant la revendication 6, caractérisé par le fait qu'un moteur d'entraînement (Am2), qui est monté de façon fixe sur le support (T), est associé à la bobine (Sp2).

8. Dispositif suivant l'une des revendications 4 à 7, caractérisé par le fait qu'un dispositif d'enlèvement et un dispositif de réception pour la feuille de revêtement (Af) de la bande (G) sont intégrés dans la cassette (K).

9. Dispositif suivant la revendication 8, caractérisé par le fait que le dispositif d'enlèvement et le dispositif de réception sont formés par une bobine entraînée (Sp3) servant à recevoir la feuille de revêtement (Af).

10. Dispositif suivant la revendication 9, caractérisé par le fait qu'un moteur d'entraînement (Am3) disposé de façon fixe sur le support (T) est associé à la bobine (Sp3).
